# EUROPEAN PATENT SPECIFICATION

(11) **EP 2 151 855 B1**
(45) Date of publication and mention of the grant of the patent: **12.03.2014**
(21) Application number: 08752721.4
(22) Date of filing: 14.05.2008
(51) Int. Cl.: H01J 37/32, H01L 21/3065, H05H 1/46

(54) **PLASMA-PROCESSING DEVICE AND METHOD OF MANUFACTURING ADHESION-PREVENTING MEMBER**
PLASMAVERARBEITUNGSEINRICHTUNG UND VERFAHREN ZUR HERSTELLUNG EINES ADHÄSION VERHINDERNDEN GLIEDS
DISPOSITIF DE TRAITEMENT PLASMA ET PROCEDE DE FABRICATION D'UN ELEMENT ANTI-ADHERENCE

(30) Priority: 18.05.2007 JP 2007132631; 01.06.2007 JP 2007146753
(43) Date of publication of application: 10.02.2010
(73) Proprietor: Ulvac, Inc., Chigasaki-shi Kanagawa 253-8543 (JP)
(72) Inventor: KOKAZE, Yutaka, Susono-shi Shizuoka 410-1231 (JP); UEDA, Masahisa, Susono-shi Shizuoka 410-1231 (JP); ENDOU, Mitsuhiro, Susono-shi Shizuoka 410-1231 (JP); SUU, Koukou, Susono-shi Shizuoka 410-1231 (JP); MIYAZAKI, Toshiya, Susono-shi Shizuoka 410-1231 (JP); SAKATA, Genji, Susono-shi Shizuoka 410-1231 (JP); NAKAMURA, Toshiyuki, Susono-shi Shizuoka 410-1231 (JP)
(74) Representative: Eisenführ Speiser
(86) International application number: PCT/JP2008/058850
(87) International publication number: WO 2008/143088

(56) References cited:
- EP-A1- 1 505 173
- JP-A- 7 273 086
- JP-A- 07 273 086
- JP-A- 10 130 872
- JP-A- 2000 124 137
- JP-A- 2000 124 137
- JP-A- 2001 068 458
- JP-A- 2004 356 311
- JP-A- 2006 303 158
- US-A- 5 882 419
- US-A1- 2002 117 473

## Description

### TECHNICAL FIELD

The present invention relates to a plasma processing apparatus and a manufacturing method of a deposition-inhibitory member.

### BACKGROUND ART

Etching processing with use of a plasma processing apparatus is performed in which a reactant gas excited into a plasma state is made to collide with a structure formed on a substrate. In the etching processing, the structure releases product such as particles of the structure bound with the reactant gas, or monolithic particles of the structure. Therefore a deposition-inhibitory plate is installed between the wall of the processing chamber and the substrate so that the products do not become attached to the wall of the processing chamber.

As a material for the deposition-inhibitory plate, there has been employed an aluminum alloy whose surface has been alumite-processed (for example, refer to Patent Document 1). Impurities (products) such as magnesium, manganese, copper, iron, silicon, nickel, and the like are added to the aluminum alloy. Consequently, in order to prevent these impurities from becoming attached to the deposition-inhibitory plate, the surface of the aluminum alloy is alumite-processed.
[Patent Document 1] Japanese Unexamined Patent Application, First Publication No. 2004-356311

Document US 2002/0117473 A1 discloses that in a plasma processing apparatus according to the present invention, a gas inlet port and a discharge port are provided on a chamber for introducing and discharging gas into and from the chamber respectively. A sample to be etched is placed on an electrode part, so that a high-frequency power source applies a high-frequency bias to the sample. An electromagnet provided on the periphery of a plasma generation area generates a magnetic field while a waveguide connected to an upper portion of the chamber introduces a microwave into the plasma generation area through a microwave introduction window. Electron cyclotron resonance is excited for the gas for generating plasma. At least a surface of the microwave introduction window exposed to the plasma generation area is made of quartz, while the gas contains fluorine. The apparatus can remove a material adhering to the surface of the microwave introduction window where the sample is etched.

Document US 5,882,419 A discloses an improved deposition chamber that deposits useful layers on substrates. The improved chamber includes a substrate edge protection system which, in combination with a purge gas, protects selected portions of the edge and underside of the substrate from the deposition gas while preventing the creation of a masked area on the substrate edge. The substrate is supported on a solid receiving plate, and a positioning assembly aligns the substrate to the receiving plate. The improved deposition chamber may include a stem interconnected to the substrate, a heat limiting member disposed about the stem, and a shroud extending about the stem.

Document EP 1 505 173 A1 discloses a shower head whose temperature can be controlled in consideration of the film-forming conditions selected and a thin film-manufacturing device which permits the stable and continuous formation of thin films including only a trace amount of particles while reproducing a good film thickness distribution and compositional distribution, and a high film-forming rate and which is excellent in the productivity and the mass-producing ability as well as a method for the preparation of such a film. The shower head is so designed that the shower head structure is incorporated into an upper cap of a film-forming vessel, that a heat-exchange means is disposed in the upper cap to thus control the temperature of the upper cap and to in turn allow heat-exchange to occur at the contact surface between a disk-like shower plate constituting the shower head surface and the upper cap and that the temperature of the shower head can be controlled in consideration of the film-forming conditions selected. A thin film-manufacturing device is equipped with the shower head in its film-forming vessel and a thin film is prepared using the device.

Document JP 07 273086 A discloses an inner cylindrical tube that prevents plasma reaction products from adhering to the side wall of a plasma generating chamber, whereby the contamination of a sample can be avoided. Further, as the heat capacity of the inner cylindrical tube is small and little heat is radiated by the heat conduction, the temperature of the inner cylindrical tube can be elevated to a predetermined temperature not lower than 200°C and hence a process using fluorocarbon gas having a high carbon content as the etching base gas can be employed easily and the selection ratio to a foundation Si film and a selection ratio to a photoresist film can be further improved.

Document JP 2000 124137 A discloses that a work is processed through the use of plasma in a reaction chamber provided to a plasma processing device, where all inner walls of the reaction chamber are covered with an aluminum layer of purity 99% or higher, and the surface roughness of the aluminum layer is 10µm or lager. An Al2O3 layer is formed on the aluminum layer.

### DISCLOSURE OF INVENTION

### [Problems to be Solved by the Invention]

However, if for example, etching processing is performed while heating the deposition-inhibitory plate in order to reduce the amount of product becoming attached to the deposition-inhibitory plate, a crack may occur in the alumite formed on the surface of the aluminum alloy in some cases. If a crack occurs in the surface of the aluminum alloy, the impurity metals contained in the aluminum alloy travel through the crack and are released into the processing chamber. Moreover, a part of the released metals becomes attached to the structure on the substrate, and consequently the structure becomes contaminated.

Among the metals attached to the structure, particularly alkaline metals and alkaline-earth metals have a characteristic in that they are likely to enter and diffuse within the structure. Therefore, if the contamination level becomes higher, the characteristics of a device formed on the substrate change, consequently influencing manufacturing yield.

The present invention takes into consideration the problems of the above conventional technique, with an object of providing a plasma processing apparatus and a method of manufacturing a deposition-inhibitory member in which metal contamination is reduced.

### [Means for Solving the Problem]

The present invention employs the following measures in order to solve the above problems and achieve the object.

A plasma processing apparatus of the present invention is an apparatus that performs, on a substrate to be processed, plasma processing with a noble metal material and a ferroelectric material and that is provided with a constituent member that is exposed to plasma while being heated, wherein the constituent member is formed such that a base substance made of an aluminum alloy is coated with a barrier type anodic oxide film, and the barrier type anodic oxide film is further coated with an aluminum sprayed film of at least 99% aluminum purity.

According to the above plasma processing apparatus, the barrier type anodic oxide film can suppress the outflow of impurities from the base substance. That is to say, the barrier type anodic oxide film has excellent heat resistance, and consequently the possibility of cracks occurring due to heat application is low. Moreover, the barrier type anodic oxide film is protected by the aluminum sprayed film, and it is consequently possible to reduce mechanical damage even in a case where the barrier type anodic oxide film is comparatively thin. Thus, it becomes possible to suppress impurity outflow from the base substance in plasma processing, and it is consequently possible to reduce metal contamination received on the substrate to be processed. Therefore, it is possible to suppress changes in the characteristics of the device formed on the substrate to be processed, and it is consequently possible to achieve an improvement in manufacturing yield and a reduction in manufacturing cost.

The barrier type anodic oxide film may be formed by subjecting a surface of an oxide film with a thickness of not less than 5 nm and not more than 20 nm to a barrier type anodization.

In this case, the surface of the dense oxide film with a thickness of 5 nm to 20 nm is subjected to a barrier type anodization, and it is thereby possible to form a dense barrier type anodic oxide film on the surface of the base substance made of an aluminum alloy. Thus, it is possible to form a barrier type anodic oxide film having excellent heat resistance and gas releasing characteristics, and it consequently becomes possible to suppress the outflow of impurities from the base substance when performing plasma processing. Furthermore, it is also possible to further reduce metal contamination received on the substrate to be processed.

The constituent member may be a deposition-inhibitory member that prevents adhesion of products of the plasma processing.

In this case, it is possible to suppress the outflow of impurities from the deposition-inhibitory member that is exposed to highly dense plasma, and it is consequently possible to reduce metal contamination received on the substrate to be processed. Thus, it is possible to suppress changes in the characteristics of the device formed on the substrate to be processed, and it is consequently possible to achieve an improvement in manufacturing yield and a reduction in manufacturing cost.

A film thickness of the aluminum sprayed film may be 100 µm or more.

In this case, the barrier type anodic oxide film is protected by the aluminum sprayed film, and it is consequently possible to reduce mechanical damage even in a case where the barrier type anodic oxide film is comparatively thin. Thus, it becomes possible to suppress impurity outflow from the base substance in plasma processing, and it is consequently possible to reduce metal contamination received on the substrate to be processed. Therefore, it is possible to suppress changes in the characteristics of the device formed on the substrate to be processed, and it is consequently possible to achieve an improvement in manufacturing yield and a reduction in manufacturing cost.

The noble metal material and the ferroelectric material may be materials that constitute a memory element of a ferroelectric memory.

The noble metal material may contain at least any one of Pt (platinum), Ir (iridium), IrO₂ (iridium oxide), and SrRuO₃ (strontium ruthenium oxide).

The ferroelectric material may contain at least any one of PZT (Pb (Zr, Ti) O₃; lead zirconium titanate), SBT (SrBi₂Ta₂O₉; strontium bismuth tantalite), BTO (Bi₄Ti₃O₁₂; bismuth titanate), and BLT ((Bi, La)₄Ti₃O₁₂; bismuth lanthanum titanate).

These noble metal material and ferroelectric material have a characteristic in that the products of the plasma processing are likely to become attached thereto. In the conventional technique described above, if the constituent member of the plasma processing apparatus is heated in order to prevent adhesion of the products, a crack occurs in the alumite that coats the constituent member. There is a possibility that impurities outflowing from this crack may become attached to the substrate to be processed, and consequently the substrate to be processed receives metal contamination. On the other hand, in the present invention, the base substance is coated with the barrier type anodic oxide film having heat resistance, and therefore no cracks occur even if the constituent member is heated, and impurity outflow can be suppressed. Thus, it is possible to suppress changes in the characteristics of the device formed on the substrate to be processed, and it is consequently possible to achieve an improvement in manufacturing yield and a reduction in manufacturing cost.

A manufacturing method of the constituent member included in the above plasma processing apparatus of the present invention includes: an oxide film coating step for coating a base substance made of an aluminum alloy with a barrier type anodic oxide film; and a sprayed film coating step for coating the barrier type anodic oxide film with an aluminum sprayed film of at least 99% aluminum purity.

According to the above manufacturing method, the base substance made of an aluminum alloy is coated with a barrier type anodic oxide film, and consequently the base substance can be coated with a barrier type anodic oxide film having excellent heat resistance. Moreover, the barrier type anodic oxide film is coated with an aluminum sprayed film of at least 99% aluminum purity. In this case, the barrier type anodic oxide film has excellent heat resistance, and consequently the possibility of cracks occurring in the barrier type anodic oxide film is low even when heated. Therefore, it is possible to suppress the outflow of impurities from the base substance. Moreover, the barrier type anodic oxide film is coated with and protected by the aluminum sprayed film, and it is consequently possible to reduce mechanical damage even in a case where this barrier type anodic oxide film is comparatively thin. Thus, impurity outflow from the base substance in plasma processing can be suppressed, and it is consequently possible to reduce metal contamination received on the substrate to be processed. Furthermore, it is possible to suppress changes in the characteristics of the device.

Prior to the oxide film coating step, there may be further provided a step for coating the base substance with an oxide film with a thickness of not less than 5 nm and not more than 20 nm, and in the oxide film coating step, a surface of the oxide film may be subjected to a barrier type anodization.

In this case, the surface of the dense oxide film with a thickness of 5 nm to 20 nm is subjected to a barrier type anodization to manufacture the constituent member, and it is thereby possible to form a dense barrier type anodic oxide film on the surface of the base substance made of an aluminum alloy. Thus, it is possible to form a barrier type anodic oxide film having excellent heat resistance and gas releasing characteristics, and it consequently becomes possible to suppress the outflow of impurities from the base substance when performing plasma processing. As a result, it is possible to further reduce metal contamination received on the substrate to be processed.

### [Effect of the Invention]

According to the above plasma processing apparatus of the present invention, the barrier type anodic oxide film can suppress impurity outflow from the base substance. That is to say, the barrier type anodic oxide film has excellent heat resistance, and consequently the possibility of cracks occurring due to heat application is low. Moreover, the barrier type anodic oxide film is protected by the aluminum sprayed film, and it is consequently possible to reduce mechanical damage even in a case where the barrier type anodic oxide film is comparatively thin. Thus, it becomes possible to suppress impurity outflow from the base substance in plasma processing, and it is consequently possible to reduce metal contamination received on the substrate to be processed. Therefore, it is possible to suppress changes in the characteristics of the device formed on the substrate to be processed, and it is consequently possible to achieve an effect of improving manufacturing yield and reducing manufacturing cost.

### BRIEF DESCRIPTION OF THE DRAWINGS

FIG. 1 is a schematic configuration diagram of an etching apparatus according to a first embodiment of the present invention.
FIG. 2 is a plan view showing the positional relationship between a permanent magnet, a first electrode, and an antenna in the same etching apparatus.
FIG. 3 is a sectional view of a FeRAM.
FIG. 4 is a schematic configuration diagram of an etching apparatus according to a second embodiment of the present invention.
FIG. 5 is a plan view showing a permanent magnet, a first electrode, and an antenna in the same etching apparatus.
FIG. 6 is an enlarged sectional view of a deposition-inhibitory member.
FIG. 7 is a sectional view of a FeRAM.

### [Description of the Reference Symbols]

1, 201 Etching apparatus
10, 210 Processing chamber
15, 215 First quartz plate
20, 220 Deposition-inhibitory member
20b Side wall section
31, 231 Permanent magnet
32, 232 First electrode
33, 233 Antenna
34, 234 First high-frequency power source
41, 241 Second electrode
42, 242 Second high-frequency power source
51, 251 Heating device
52, 252 Supporting member
53, 253 Second quartz plate
60, 260 Gas supplying device
70, 270 Gas discharging device
80, 280 Cooling device
90, 290 Substrate
100, 300 FeRAM
101, 301 Silicon substrate
102, 302 Lower electrode
103, 303 Ferroelectric layer
104, 304 Upper electrode
221 Base substance
222 Dense oxide film
223 Barrier type anodic oxide film
224 Aluminum sprayed film

### BEST MODE FOR CARRYING OUT THE INVENTION

### (Configuration of plasma processing apparatus)

Hereunder there is described, with reference to the drawings, a plasma processing apparatus according to the present invention. Respective embodiments illustrated below describe an inductively-coupling type reactive ion etching apparatus, however, the invention can also be applied to an apparatus that forms thin films such as a chemical vapor deposition film.

Each of the following respective embodiments illustrates an example of the present invention and does not limit the invention, and it may be arbitrarily modified without departing from the technical concept of the present invention. Moreover, in the following drawings, in order to facilitate understanding of the respective configurations, the scale or number of the respective structures may differ from those in the actual structures in some cases.

### [First embodiment]

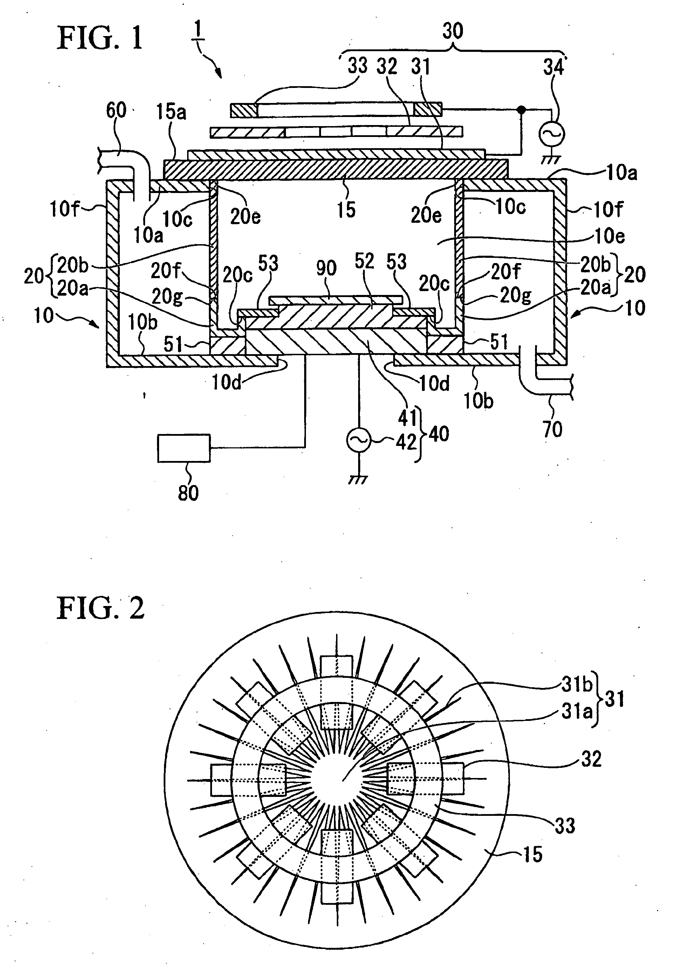

FIG. 1 is a schematic configuration diagram of an etching apparatus (plasma processing apparatus) 1 of the present invention. The etching apparatus 1 is provided with a processing chamber 10, an deposition-inhibitory member 20, a plasma generating device 30, a bias generating device 40, a first quartz plate 15, a heating device 51, a supporting member 52, a second quartz plate 53, a gas supplying device 60, a gas discharging device 70, and a cooling device 80. The plasma generating device 30 is provided with a first electrode 31, permanent magnets 32, an antenna 33, and a first high-frequency power source 34. The bias generating device 40 is provided with a second electrode 41 and a second high-frequency power source 42.

The processing chamber 10 is formed in a column shape, and a ceiling wall 10a thereof has an opening section 10c and a bottom wall 10b thereof has an opening section 10d. On the outer side of the ceiling wall 10a of the processing chamber 10 there is placed the first quartz plate 15 so as to cover the opening section 10c. On the first quartz plate 15 there is placed the first electrode 31. Above the first electrode 31 there are arranged the permanent magnets 32, and furthermore on the permanent magnets 32 there is arranged the antenna 33. To the first electrode 31 and the antenna 33 there is electrically connected the first high-frequency power source 34. On the inner side of the bottom wall 10b of the processing chamber 10 there is placed the second electrode 41 so as to cover the opening section 10d, and furthermore, above the second electrode 41 there is placed the supporting member 52. To the second electrode 41 there is connected the second high-frequency power source 42. The supporting member 52 is formed such that the center section thereof is thicker than the periphery section thereof when seen in a sectional view, and on the center section thereof there is placed a substrate 90. On the periphery section of the supporting member 52 there is placed the second quartz plate 53. On the inner surface of the bottom wall 10b of the processing chamber 10 there is placed, along the outer circumference of the opening section 10d, the heating device 51. On the heating device 51 there is placed the substantially cylindrical deposition-inhibitory member 20. Details of this deposition-inhibitory member 20 are described later. An upper end section 20e of the deposition-inhibitory member 20 is in contact with the first quartz plate 15.

In the processing chamber 10, etching is performed on the substrate 90 using plasma generated by the plasma generating device 30.

The first quartz plate 15 is of a substantially circular disk shape in plan view. The first quartz plate 15 is arranged so as to cover the opening section 10c of the processing chamber 10, and is used for sealing the opening section 10c and is used as a base upon which the first electrode 31 is arranged.

On an upper surface 15a of the first quartz plate 15 there is arranged the first electrode 31. FIG. 2 is a plan view showing the first electrode 31, the permanent magnets 32, and the antenna 33 being arranged on the first quartz plate 15. As shown in FIG. 2, the first electrode 31 has a structure such that a plurality of arm sections 31b are arranged in a pattern radiating from a central shaft 31a. To the central shaft 31a of the first electrode 31 there is connected a rotating device not shown in the drawing, capable of rotating the first electrode 31 in the circumferential direction. The first electrode 31 is used to attract plasma particles to the first electrode 31 side to thereby remove products that have been attached to the first quartz plate 15 as a result of the etching processing.

The permanent magnets 32 are of a substantially rectangular shape in plan view, and are arranged at equal intervals in the circumferential direction, with the N pole thereof facing inward.

The antenna 33 is a circular flat plate in plan view. For the antenna 33, a circular antenna, a coil antenna, or the like may be employed.

The deposition-inhibitory member 20 is to prevent particles released from the substrate 90 in etching from being attached to a side wall section 10f of the processing chamber 10, and is formed along the side wall section 10f of the processing chamber 10, in a substantially cylindrical shape. The deposition-inhibitory member 20 is configured with a bottom section 20a that is arranged to the bottom wall 10b side of the processing chamber 10 from the substrate 90 when seen in a sectional view, and a side wall section 20b that is arranged to the ceiling wall 10a side of the processing chamber 10 from the substrate 90 when seen in a sectional view. The deposition-inhibitory member 20 is formed such that an upper end section 20f on the outer circumferential side of the bottom section 20a and a lower end section 20g of the side wall section 20b are joined by means of welding. The bottom section 20a of the deposition-inhibitory member 20 is placed on the heating device 51.

The bottom section 20a of the deposition-inhibitory member 20 is formed in a U shape when seen in a sectional view. The thickness of the deposition-inhibitory member 20 is approximately 5 mm. For the bottom section 20a of the deposition-inhibitory member 20 of the present embodiment, there is used a material having heat resistance and mechanical strength. Examples of the material to be used for the bottom section 20a include an aluminum alloy AA5052. AA5052 is one of the aluminum alloys standardized by the Aluminum Association of America. AA5052 is an aluminum alloy such that 2.2% to 2.8% magnesium and other elements are added to aluminum, and has an improved mechanical strength compared to that of monolithic aluminum. Moreover, the material to be used for the bottom section 20a is not limited to this, and may be substituted by another material having a high level of mechanical strength and a low ratio of impurity metal content.

Meanwhile, the side wall section 20b of the deposition-inhibitory member 20 is formed in a cylindrical shape. The side wall section 20b of the deposition-inhibitory member 20 is a member that receives the largest amount of interaction from particles in a plasma state. Examples of the material of the side wall section 20b include an aluminum alloy AA1050. AA1050 is one of aluminum alloys standardized by the Aluminum Association of America. AA1050 has an aluminum purity of at least 99%, and the magnesium content ratio thereof is 0.05% or less. The material of the side wall section 20b is not limited to this, and may be substituted by a material having an aluminum purity of at least 99% and a content ratio of 0.1 % or less of alkaline-earth metal such as magnesium and alkaline metal. This is because alkaline metal and alkaline-earth metal are highly likely to be diffused into the substrate 90, and consequently change the characteristics of the substrate 90.

The heating device 51 is arranged so as to surround the opening section 10d of the bottom wall 10b of the processing chamber 10, and is formed in a substantially circular shape. For the heating device 51, there may be employed metallic or ceramics resistive body. The heating device 51 is provided for heating the deposition-inhibitory member 20, and heats the deposition-inhibitory member 20 to 150°C when performing etching processing.

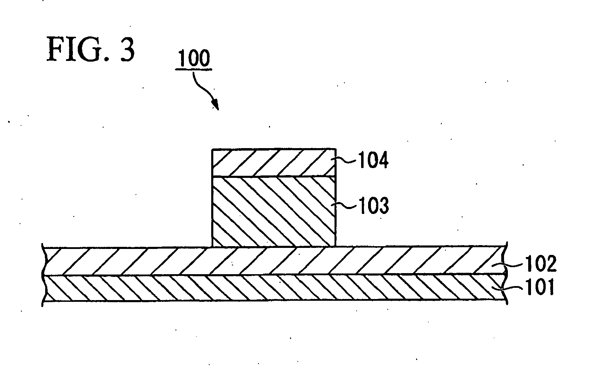

A FeRAM (Ferroelectric Random Access Memory) may be taken as an example of the device formed on the substrate 90. FIG. 3 is a sectional view of a FeRAM 100. The FeRAM 100 has a configuration such that on a silicon substrate 101 there are laminated a lower electrode 102, a ferroelectric layer 103, and an upper electrode 104.

The lower electrode 102 and the upper electrode 104 are formed in a thin film shape. As a material for the lower electrode 102 and the upper electrode 104, there may be employed a noble metal material such as Pt (platinum), Ir (iridium), IrO₂ (iridium oxide), and SrRuO₃ (strontium ruthenium oxide). As a material for the ferroelectric layer 103, there may be employed a ferroelectric material such as PZT (Pb(Zr, Ti)O₃; lead zirconium titanate), SBT (SrBi₂Ta₂O₉; strontium bismuth tantalite), BTO (Bi₄Ti₃O₁₂; bismuth titanate), and BLT ((Bi, La)₄Ti₃O₁₂; bismuth lanthanum titanate).

The FeRAM 100 is such that when an electric field is applied to the ferroelectric layer 103 based on the electrical potential difference between the lower electrode 102 and the upper electrode 104, the direction of the spontaneous polarization of the ferroelectric layer 103 can be changed. The direction of this spontaneous polarization can still be maintained even when the electric potential difference between the lower electrode 102 and the upper electrode 104 is no longer present, and it is consequently possible to store data of 0 or 1 based on the orientation of the spontaneous polarization.

### (Etching method)

Next, there is described an etching method with use of the etching apparatus 1 of the present invention.

The substrate 90 is placed on the supporting member 52, the interior of the processing chamber 10 is made substantially a vacuum, and the heating device 51 is driven to thereby heat the deposition-inhibitory member 20.

Having sufficiently heated the deposition-inhibitory member 20, an etching gas is supplied from the gas supplying device 60 into the processing chamber 10. The supplied gas, for example, is a halogen gas, a perfluorocarbon gas, or the like. During performance of the etching processing, the gas discharging device 70 is driven and the pressure within the processing chamber 10 is thereby maintained constant.

Next, the first high-frequency power source 34 is driven to supply high-frequency electric current to the first electrode 31 and the antenna 33, and thereby the etching gas within a region 10e inside the processing chamber 10 is excited into a plasma state.

Subsequently, the second high-frequency power source 42 is driven, and high-frequency electric current is thereby supplied to the second electrode 41. Thus, the etching gas that has been excited into a plasma state is guided to the second electrode 41. As a result, the etching gas collides with the substrate 90 placed on the supporting member 52 and with a film for a device formed on the substrate 90 , and consequently the substrate 90 and the film for the device are etched. At this time, products such as particles of the film for the device bound with the etching gas and monolithic particles of the film for the device, are released from the substrate 90.

The products released from the substrate 90 travel through the gas discharging device 70 and are discharged from the processing chamber 10, or they become attached to the surrounding walls of the deposition-inhibitory member 20 and so forth and remain inside the processing chamber 10.

### (Operations and effects)

Hereunder, there are described operations and effects of the above plasma processing apparatus 1.

In the present embodiment, a material having a high degree of aluminum purity is employed for the side wall section 20b of the deposition-inhibitory member 20, and thereby the content ratio of contaminated metal contained in the side wall section 20b is reduced. Consequently, even if the side wall section 20b is exposed to highly dense plasma, segregation of contaminated metal from the side wall section 20b is highly unlikely. Therefore, the contamination level of the substrate 90 when performing the plasma processing can be reduced. Thus, it is possible to improve manufacturing yield of the substrate 90 while reducing manufacturing cost. Moreover, alumite treatment on the surface of the side wall section 20b is no longer required, and the aluminum alloy has a thermal conductivity higher than that of an alumite. Therefore it is possible to improve the thermal conductivity of the deposition-inhibitory member 20. Thus, the heating device 51 efficiently performs heat application to the deposition-inhibitory member 20, and it is consequently possible to reduce the amount of products released from the substrate 90 that become attached to the deposition-inhibitory member 20. Thus, it is possible to reduce maintenance frequency of the deposition-inhibitory member 20.

A material having mechanical strength is employed for the bottom section 20a of the deposition-inhibitory member 20, and the mechanical strength of the deposition-inhibitory member 20 can be thereby improved. Consequently, it is possible to suppress deformation in the deposition-inhibitory member 20 during the process of manufacturing or maintenance and it is consequently possible to extend the life span of the deposition-inhibitory member 20. Thus, it is possible to suppress maintenance cost for the etching apparatus 1.

As a material for the deposition-inhibitory member 20, there may employed, for example, a standardized material such as AA1050 and AA5052, and thereby an inexpensive material can be easily procured. Consequently, it is possible to suppress manufacturing cost for the deposition-inhibitory member 20.

### (Working example)

Next there is described a working example of a contamination level evaluation performed with use of the above etching apparatus 1.

Here a method of evaluating the contamination level of the substrate 90 is described. As the substrate 90, there is used a silicon wafer having a SiO₂ (silicon dioxide) film formed on the surface thereof. This substrate 90 is exposed to argon gas plasma.

SiO₂ of the substrate 90 with contaminated metal attached thereto is dissolved in hydrofluoric acid. This hydrofluoric acid containing SiO2 is analyzed and the atomicity of the contaminated metal in the hydrofluoric acid is derived. The atomicity of the contaminated metal obtained in this way is calculated per unit area of the substrate 90 to thereby evaluate contamination level.

In the present working example, aluminum alloy AA1050 was employed as a material for the bottom section 20a of the deposition-inhibitory member 20 in the etching apparatus 1, and aluminum AA5052 was used as a material for the side wall section 20b of the deposition-inhibitory member 20. The deposition-inhibitory member 20 was formed such that the upper end section 20f on the outer circumferential side of the bottom section 20a and the lower end section 20g of the side wall section 20b were joined by means of welding.

The substrate 90 was arranged on the supporting member 52 of the etching apparatus 1, the processing chamber was made substantially a vacuum, and the deposition-inhibitory member 20 was heated to 150°C or higher with use of the heating device 51. Subsequently, argon gas, as an etching gas, was supplied from the gas supplying device 60 into the processing chamber 10. Moreover, the output of the gas discharging device 70 was adjusted to thereby maintain the pressure within the processing chamber constant.

Having made the pressure within the processing chamber 10 constant, the first high-frequency power source 34 was driven, and the argon gas in the region 10e within the processing chamber 10 was excited into a plasma state.

In a state where the first high-frequency power source 34 was driven, the second high-frequency power source 42 was driven, and the argon gas excited into a plasma state was made to collide with the substrate 90 to thereby expose the substrate 90 to the plasma.

The substrate 90 after being exposed to the plasma was taken out of the processing chamber 10, and was then washed with hydrofluoric acid. Subsequently, the hydrofluoric acid used for washing the substrate 90 was analyzed, and thereby the number of magnesium elements contained in the hydrofluoric acid was derived. As a result of the analysis, the contamination level of the substrate 90 was 2.6 × 10¹⁰ elements / cm².

In a conventional etching apparatus, AA5052 was used as a material for the entire deposition-inhibitory member. The contamination level of the substrate, with use of the conventional etching apparatus, was 21 × 10¹⁰ elements / cm², and accordingly it was confirmed that the contamination level of the substrate 90 can be improved with use of the etching apparatus 1 of the present invention.

### [Second embodiment]

### (Configuration of plasma processing apparatus)

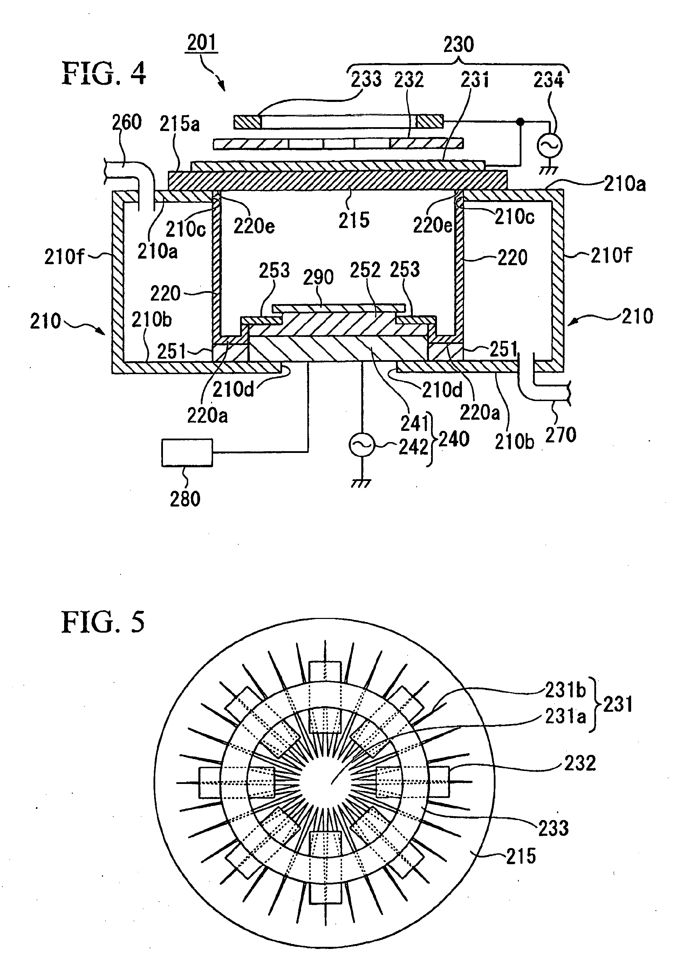

FIG. 4 is a schematic configuration diagram of an etching apparatus (plasma processing apparatus) 201 of the present invention. The etching apparatus 201 is provided with a processing chamber 210, a deposition-inhibitory member 220, a plasma generating device 230, a bias generating device 240, a first quartz plate 215, a heating device 251, a supporting member 252, a second quartz plate 253, a gas supplying device 260, a gas discharging device 270, and a cooling device 280. The plasma generating device 230 is provided with a first electrode 231, permanent magnets 232, an antenna 233, and a first high-frequency power source 234. The bias generating device 240 is provided with a second electrode 241 and a second high-frequency power source 242.

The processing chamber 210 is formed in a column shape, and a ceiling wall 210a thereof has an opening section 210c and a bottom wall 210b thereof has an opening section 210d. On the outer side of the ceiling wall 210a of the processing chamber 210 there is placed the first quartz plate 215 so as to cover the opening section 210c. On the first quartz plate 215 there is placed the first electrode 231. Above the first electrode 231 there are arranged the permanent magnets 232, and furthermore above the permanent magnets 232 there is arranged the antenna 233. To the first electrode 231 and the antenna 233 there is electrically connected the first high-frequency power source 234. On the inner side of the bottom wall 210b of the processing chamber 210 there is placed the second electrode 241 so as to cover the opening section 210d, and furthermore, on the second electrode 241 there is placed the supporting member 252. To the second electrode 241 there is connected the second high-frequency power source 242. The supporting member 252 is formed such that the center section thereof is thicker than the periphery section thereof when seen in a sectional view, and on the center section thereof there is placed a substrate 290. On the periphery section of the supporting member 252 there is placed the second quartz plate 253. On the inner surface of the bottom wall 210b of the processing chamber 210 there is placed, along the outer circumference of the second electrode 241, the heating device 251. On the heating device 251 there is placed the substantially cylindrical deposition-inhibitory member 220. Details of this deposition-inhibitory member 220 are described later. An upper end section 220e of the deposition-inhibitory member 220 is in contact with the first quartz plate 215.

In the processing chamber 210, etching is performed on the substrate 290 using plasma generated by the plasma generating device 230.

The first quartz plate 215 is of a substantially circular disk shape in plan view. The first quartz plate 215 is arranged so as to cover the opening section 210c of the processing chamber 210, and is used for sealing the opening section 210c and is used as a base upon which the first electrode 231 is arranged.

On an upper surface 215a of the first quartz plate 215 there is arranged the first electrode 231. FIG. 5 is a plan view showing the first electrode 231, the permanent magnets 232, and the antenna 233 being arranged on the first quartz plate 215. As shown in FIG. 5, the first electrode 231 has a structure such that a plurality of arm sections 231b are arranged in a pattern radiating from a central shaft 231a. To the central shaft 231a of the first electrode 231 there is connected a rotating device not shown in the drawing, capable of rotating the first electrode 231 in the circumferential direction. The first electrode 231 is used to attract plasma particles to the first electrode 231 side to thereby remove products that have been attached to the first quartz plate 215 as a result of the etching processing.

The permanent magnets 232 are of a substantially rectangular shape in plan view, and are arranged at equal intervals in the circumferential direction, with the N pole thereof facing inward.

The antenna 233 is a circular flat plate in plan view. For the antenna 233, a circular antenna, a coil antenna, or the like may be employed.

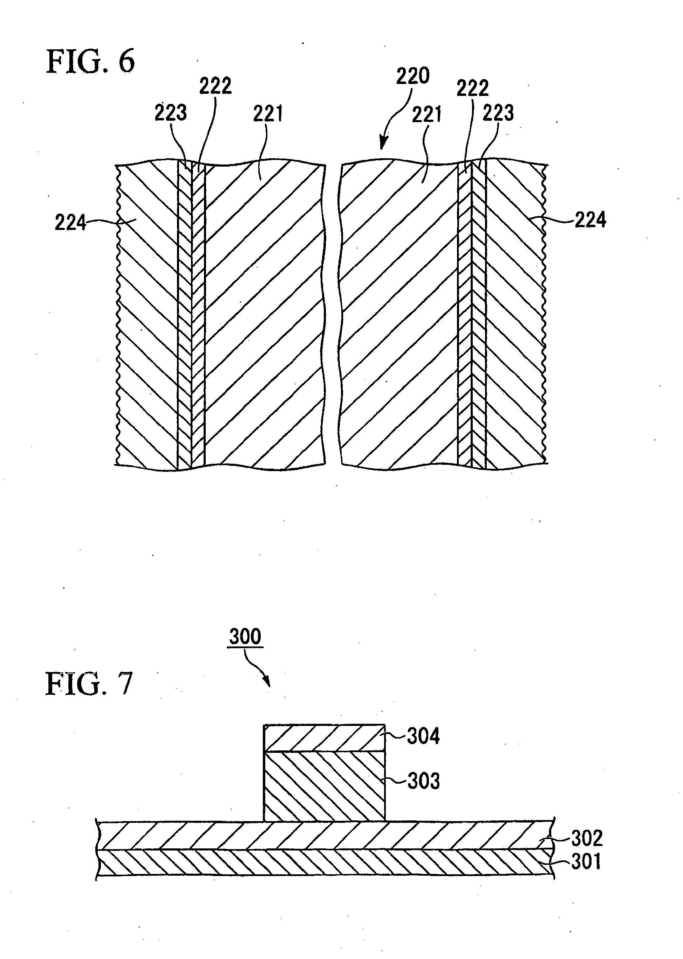

The deposition-inhibitory member 220 is to prevent particles released from the substrate 290 due to etching from becoming attached to a side wall section 210f of the processing chamber 210. FIG. 6 is an enlarged conceptual diagram of the deposition-inhibitory member 220. The deposition-inhibitory member 220 has a base substance 221, a dense oxide film 222 that coats the base substance 221, a barrier type anode oxide film 223 that coats the dense oxide film 222, and an aluminum sprayed film 224 that coats the barrier type anodic oxide film 223.

The deposition-inhibitory member 220 is formed in a substantially cylindrical shape along the side wall section 210f of the processing chamber 210, and on a bottom section 220a of the deposition-inhibitory member 220, it is formed in a U shape when seen in a sectional view. Moreover, the thickness of the deposition-inhibitory member 220 is approximately 5 mm.

For the base substance 221 of the deposition-inhibitory member 220 of the present embodiment, there is used a material having heat resistance and mechanical strength, and an aluminum alloy AA5052 may be taken as an example thereof. AA5052 is one of the aluminum alloys standardized by the Aluminum Association of America. AA5052 is an aluminum alloy such that 2.2% to 2.8% magnesium and other elements are added to aluminum, and has an improved mechanical strength compared to that of monolithic aluminum. Moreover, the material to be used for the base substance 221 is not limited to this, and may be substituted by another aluminum alloy having heat resistance and mechanical strength.

The dense oxide film 222 is a thin film that is formed as a preprocessing for forming the barrier type anodic oxide film 223. In the present embodiment, the dense oxide film refers to, except for defects associated with non-metal inclusions present, a continuous film having no pores greater than the order of nanometers, and is a layer in which even if promotion of oxidization is attempted by oxidizing in an atmosphere after the oxide film has been formed, the thickness of the oxide film does not get thicker than it already is. The dense oxide film 222 has heat resistance and has a low level of crack occurrence associated with heat application, and it is consequently possible to suppress the outflow of impurities from the base substance 221 when performing etching processing.

The dense oxide film 222 is formed with a film thickness 5 nm to 20 nm. If the film thickness is less than 5 nm, it is difficult to grow this oxide film in a continuous layer form, and it consequently becomes an uneven oxide film. On the other hand, if the film thickness exceeds 20 nm, the dense oxide layer cannot be formed and it becomes a porous structure. Moreover, even if a barrier type anodic oxide film is formed after this, it becomes a barrier type anodic oxide film with a high level of gas release. Consequently, if such oxide film 222 is formed, it becomes impossible to suppress the outflow of impurities from the base substance 221.

The barrier type anodic oxide film 223 has heat resistance and has a low level of crack occurrence associated with heat application, and it is consequently possible to suppress the outflow of impurities from the base substance 221 when performing etching processing. The barrier type anodic oxide film 223 is formed with an approximately 200 nm thickness. In particular, by having the surface of the aforementioned dense oxide film 222 subjected to a barrier type anodization, even with the surface of an aluminum alloy containing impurities, it is possible to form the dense barrier type anodic oxide film 223.

The deposition-inhibitory member 220 may have a structure such that the dense oxide film 222 is not coated with the base substance 221 and the barrier type anodic oxide film 223 directly coats the base substance 221. In this case, the surface of the barrier type anodic oxide film 223 is subjected to a baking processing, to thereby reduce the water content ratio and the amount ofanion content with respect to aluminum. It is also possible, with such a barrier type anodic oxide film 223, to suppress the outflow of impurities.

The aluminum sprayed film 224 is formed by spraying aluminum of at least 99% purity. The aluminum sprayed film 224 is used to prevent mechanical damage that the barrier type anodic oxide film 223 receives when detaching the deposition-inhibitory member 220 in maintenance. Moreover, the aluminum sprayed film 224 is also used to suppress etching products released from the substrate 290 from becoming attached to the deposition-inhibitory member 220.

The surface of the aluminum sprayed film 224 is not flat, and the surface roughness (Ra) thereof is approximately 10 µm to 50 µm. The deposition-inhibitory member 220 is heated by the heating device 251 so that products are unlikely to become attached thereto. However, even if products become attached thereto, it is possible, due to an anchor effect based on the surface roughness of the aluminum sprayed film 224, to accumulate the products without the products detaching from the aluminum sprayed film 224. Thus, it is possible to prevent particle contamination within the processing chamber 210 due to the products.

The preferable film thickness of the aluminum sprayed film 224 is not less than 100 µm and not more than 200 µm. This is because if the film thickness is less than 100 µm, the barrier type anodic oxide film 223 cannot be sufficiently protected, and if it is greater than or equal to 200 µm, adhesion on the barrier type anodic oxide film 223 decreases.

FIG. 6 shows the deposition-inhibitory member 220 in which the dense oxide film 222, the barrier type anodic oxide film 223, and the aluminum sprayed film 224 are coated on the entire surface of the base substance 221. However, it is also possible to use an deposition-inhibitory member with only the inner side to be exposed to plasma having a coating thereon.

The heating device 251 is arranged so as to surround the opening section 210d of the bottom wall 210b of the processing chamber 210, and is formed in a substantially circular shape. For the heating device 251, there may be employed metallic or ceramics resistive body. The heating device 251 is provided for heating the deposition-inhibitory member 220, and heats the deposition-inhibitory member 220 to 150°C when performing etching processing.

A FeRAM (Ferroelectric Random Access Memory) may be taken as an example of the device formed on the substrate 290. FIG. 7 is a sectional view of a FeRAM 300. The FeRAM 300 has a configuration such that on a silicon substrate 301 there are laminated a lower electrode 302, a ferroelectric layer 303, and an upper electrode 304.

The lower electrode 302 and the upper electrode 304 are formed in a thin film shape. As a material for the lower electrode 302 and the upper electrode 304, there may be employed a noble metal material such as Pt (platinum), Ir (iridium), IrO₂ (iridium oxide), and SrRuO₃ (strontium ruthenium oxide). As a material for the ferroelectric layer 303, there may be employed a ferroelectric material such as PZT (Pb (Zr, Ti) O₃; lead zirconium titanate), SBT (SrBi₂Ta₂O₉; strontium bismuth tantalite), BTO (Bi₄Ti₃O₁₂; bismuth titanate), and BLT ((Bi, La)₄Ti₃O₁₂; bismuth lanthanum titanate).

The FeRAM 300 is such that when an electric field is applied to the ferroelectric layer 303 based on the electrical potential difference between the lower electrode 302 and the upper electrode 304, the direction of the spontaneous polarization of the ferroelectric layer 303 can be changed. The direction of this spontaneous polarization can still be maintained even when the electric potential difference between the lower electrode 302 and the upper electrode 304 is no longer present, and it is consequently possible to store data of 0 or 1 based on the orientation of the spontaneous polarization.

### (Manufacturing method of the deposition-inhibitory member 220)

Here there is described a manufacturing method of the deposition-inhibitory member 220.

First, the surface of the base substance 221 is polished by means of a sand blasting method or the like. As a result of the polishing, the surface roughness of the base substance 221 becomes approximately 5 µm or less. The polishing is performed in order to improve adhesion of the dense oxide film 222 that is to be formed subsequently.

On the base substance 221, the surface of which has been polished, there is performed processing for forming the dense oxide film 222.

First, an acidic solution containing 50% by weight to 80% by weight of phosphoric acid and 1% by weight to 5% by weight of nitric acid, is heated to approximately 80°C to 100°C. Subsequently, the base substance 221 is immersed in the heated acidic solution for one to ten minutes to thereby form the dense oxide film 222.

There may be employed a method in which ozone is generated in an oxygen atmosphere or in air with use of an ultraviolet lamp, and the surface of the base substance is oxidized with the generated ozone to thereby form the dense oxide film 222.

The formed dense oxide film 222 is heated to 150°C to 300°C under vacuum, or in air or a nitrogen atmosphere.

Next, the base substance 221 with the dense oxide film 222 formed thereon is electrolyzed with an electrolyte solution, and the barrier type anodizatoin is performed.

As the electrolyte solution, there may be employed a solution of an adipate such as ammonium adipate, a borate such as ammonium borate, a silicate, a phthalate, or the like, or a mixed liquid of these. The electrolyzation is performed where the base substance 221 serves as an anode. The current density to be used for the electrolyzation is approximately 0.2 A/cm² to 5 A/cm², and the applied voltage in the electrolyzation is approximately 20 V to 500 V. Thus, it is possible to form the barrier type anodic oxide film 223.

Subsequently, there is performed a step of forming the aluminum sprayed film 224 on the barrier type anodic oxide film 223 by means of spraying.

As a mode of spraying, for example, plasma spraying is described. An inactive gas such as argon is caused to flow between electrodes of a plasma spraying device, and electrical discharging is performed, to thereby ionize the inactive gas and generate plasma. The generated plasma has high temperature and speed, and it is possible, with aluminum powder fed into the plasma, to form aluminum droplets. The aluminum droplets carried on the flow of the plasma are sprayed so as to coat the barrier type anodic oxide film 223 on the surface of the deposition-inhibitory member 220, and thereby the aluminum sprayed film 224 is formed.

The spraying method for forming the aluminum sprayed film 224 is not particularly limited, and flame spraying, plasma spraying, laser spraying, or the like may also be used.

### (Etching method)

Next, there is described an etching method with use of the etching apparatus 201 of the present invention.

The substrate 290 is placed on the supporting member 252 shown in FIG. 4, the interior of the processing chamber 210 is made substantially a vacuum, and the heating device 251 is driven, to thereby heat the deposition-inhibitory member 220.

Having sufficiently heated the deposition-inhibitory member 220, an etching gas is supplied from the gas supplying device 260 into the processing chamber 210. The supplied gas, for example, is a halogen gas, a perfluorocarbon gas, or the like. During performance of the etching processing, the gas discharging device 270 is driven and the pressure within the processing chamber 210 is thereby maintained constant.

Next, the first high-frequency power source 234 is driven to supply high-frequency electric current to the first electrode 231 and the antenna 233, and thereby the etching gas within the processing chamber 210 is excited into a plasma state.

Subsequently, the second high-frequency power source 242 is driven, and high-frequency electric current is thereby supplied to the second electrode 241. Thus, the etching gas that has been excited into a plasma state is guided to the second electrode 241. As a result, the etching gas collides with the substrate 290 placed on the supporting member 252 and with a film for a device formed on the substrate 290, and consequently the substrate 290 and the film for the device are etched. At this time, products such as particles of the film for the device bound with the etching gas and monolithic particles of the film for the device, are released from the substrate 290.

The products released from the substrate 290 travel through the gas discharging device 270 and are discharged from the processing chamber 210, or they become attached to the surrounding walls of the deposition-inhibitory member 220 and so forth and remain inside the processing chamber 210.

### (Operations and effects)

Hereunder, there are described operations and effects of the plasma processing apparatus 201 of the present invention.

In the present embodiment, the barrier type anodic oxide film 223 can suppress the outflow of impurities from the base substance 221. That is to say, the barrier type anodic oxide film 223 has excellent heat resistance, and consequently the possibility of cracks occurring due to heat application is low. Moreover, the barrier type anodic oxide film 223 is protected by the aluminum sprayed film 224, and it is consequently possible to reduce mechanical damage even in a case where the barrier type anodic oxide film 223 is comparatively thin. Thus, it becomes possible to suppress impurity outflow from the base substance in plasma processing, and it is consequently possible to reduce metal contamination that the substrate 290 receives. Therefore, it is possible to suppress changes in the characteristics of the device formed on the substrate 290, and it is consequently effective for improving manufacturing yield and for reducing manufacturing cost.

The aluminum sprayed film 224 has a thermal conductivity higher than that of the base substance 221, and it is therefore possible to improve the thermal conductivity of the deposition-inhibitory member 220. Thus, the heating device 251 efficiently performs heat application to the deposition-inhibitory member 220, and it is consequently possible to reduce the amount of products released from the substrate 290 that become attached to the deposition-inhibitory member 220. Thus, it is possible to reduce maintenance frequency of the deposition-inhibitory member 220.

Furthermore, the film surface of the aluminum sprayed film 224 has a surface roughness (Ra) 10 µm to 50 µm, and it is consequently possible, due to an anchor effect, to improve adhesion of the products attached to the aluminum sprayed film 224. Therefore, it is possible to prevent the attached products from detaching from the aluminum sprayed film 224, and it is consequently possible to prevent particle contamination associated with the products in the interior of the processing chamber 210.

If the entire deposition-inhibitory member 220 is formed with high-purity aluminum, it is possible to prevent substrate contamination. However, the mechanical strength of high-purity aluminum is lower than that of aluminum alloy, and there is a possibility that mechanical stress received when taking out the deposition-inhibitory member from the processing chamber in maintenance may deform the deposition-inhibitory member. However, by employing an aluminum alloy having a mechanical strength as the base substance 221 of the deposition-inhibitory member 220 of the present embodiment, the mechanical strength of the deposition-inhibitory member 220 can be improved. Thus, it becomes possible to suppress deformation in the deposition-inhibitory member 220 that occurs when manufacturing or performing maintenance, and it is consequently possible to extend the life span of the deposition-inhibitory member 220. Thus, it is possible to suppress maintenance cost for the etching apparatus 201.

As a material for the deposition-inhibitory member 220, there may employed, for example, a standardized material such as AA5052, and thereby an inexpensive material can be easily procured. Consequently, it is possible to suppress manufacturing cost for the deposition-inhibitory member 220.

### (Working example)

Next, there is described a working example of a contamination level evaluation performed with use of the etching apparatus 201 of the present invention.

Here, a method of evaluating the contamination level of the substrate 290 is described. As the substrate 290, there is used a silicon wafer having a SiO₂ (silicon dioxide) film formed on the surface thereof. This substrate 290 is introduced into the etching apparatus 201, and is exposed to argon gas plasma.

SiO₂ of the substrate 290 with contaminated metal attached thereto is dissolved in hydrofluoric acid. This hydrofluoric acid containing SiO₂ is analyzed and the atomicity of the contaminated metal in the hydrofluoric acid is derived. The atomicity of the contaminated metal obtained in this way is calculated per unit area of the substrate 290 to thereby evaluate the contamination level.

In the present working example, aluminum alloy AA5052 was employed as a material of the base substance 221 of the deposition-inhibitory member 220 in the etching apparatus 201.

The base substance 221 was immersed for two minutes in an acidic solution that contained 80% by weight of phosphoric acid and 3% by weight of nitric acid and that was set at 85°C, and then it was washed with purified water, to thereby form the dense oxide film 222.

The base substance 221 having the dense oxide film 222 formed thereon was immersed in an electrolyte solution that contained 10% by weight of ammonium adipate and that was set at 40°C, and direct electric current with a voltage of 200V was applied for one hour, to thereby form the barrier type anodic oxide film 223. Thus, the oxide film 222 was formed. The film thickness of the formed oxide film 222 was 20 nm.

Aluminum of at least 99% purity was sprayed on the oxide film 222 formed in this way by means of a plasma spraying method with use of argon gas, and the 200 µm aluminum sprayed film 224 was thereby formed.

The substrate 290 was arranged on the supporting member 252 of the etching apparatus 201, the processing chamber was made substantially a vacuum, and the deposition-inhibitory member 220 was heated to 150°C or higher with use of the heating device 251. The argon gas was supplied from the gas supplying device 260 into the interior of the processing chamber 210. Moreover, the output of the gas discharging device 270 was adjusted to thereby maintain the pressure within the processing chamber constant.

Having made the pressure within the processing chamber 210 constant, the first high-frequency power source 234 was driven, and the argon gas within the processing chamber 210 was excited into a plasma state.

In a state where the first high-frequency power source 234 was driven, the second high-frequency power source 242 was driven and the argon gas excited into a plasma state was made to collide with the substrate 290 to thereby expose the substrate 290 to the plasma.

The substrate 290 after being exposed to the plasma was taken out of the processing chamber 210, and was then washed with hydrofluoric acid. Subsequently, the hydrofluoric acid used for washing the substrate 290 was analyzed, and thereby the number of magnesium elements contained in the hydrofluoric acid was derived. As a result of the analysis, the contamination level of the substrate 290 with use of the etching apparatus 201 of the working example was 2.6 × 10¹⁰ elements / cm².

In a conventional etching apparatus, there was used an deposition-inhibitory member in which the surface of the base substance 221 made of AA5052 was alumite coated. The contamination level, with use of the conventional etching apparatus, was 21 × 10¹⁰ elements / cm². Accordingly it was confirmed that the contamination level of the substrate 290 can be improved with use of the etching apparatus 1 of the present invention.

### INDUSTRIAL APPLICABILITY

According to the plasma processing apparatus of the present invention, it is possible to suppress the content ratio of impurities contained in the constituent member, and it is consequently possible to reduce metal contamination received on the substrate to be processed. Thus, it is possible to suppress changes in the characteristics of the device formed on the substrate to be processed, and it is consequently possible to achieve an improvement in manufacturing yield and a reduction in manufacturing cost.

Moreover, according to another plasma processing apparatus of the present invention, the barrier type anodic oxide film can suppress impurity outflow from the base substance. That is to say, the barrier type anodic oxide film has excellent heat resistance, and consequently the possibility of cracks occurring due to heat application is low. Moreover, the barrier type anodic oxide film is protected by the aluminum sprayed film, and it is consequently possible to reduce mechanical damage even in a case where the barrier type anodic oxide film is comparatively thin. Thus, it becomes possible to suppress impurity outflow from the base substance in plasma processing, and it is consequently possible to reduce metal contamination received on the substrate to be processed. Thus, it is possible to suppress changes in the characteristics of the device formed on the substrate to be processed, and it is consequently possible to achieve an improvement in manufacturing yield and a reduction in manufacturing cost.

## Claims

1. A plasma processing apparatus, which is configured to perform, on a substrate to be processed, plasma processing with a noble metal material and a ferroelectric material, and which comprises a constituent member (220) that is exposed to plasma, wherein a base substance (221) of the constituent member (220) is made of an aluminum alloy, **characterized in that**
the constituent member (220) is adapted to be heated, the base substance (221) of the constituent member (220) is coated with a barrier type anodic oxide film (223), and the barrier type anodic oxide film (223) is further coated with an aluminum sprayed film (224) of at least 99% aluminum purity.

2. The plasma processing apparatus according to claim 1, wherein
the barrier type anodic oxide film (223) is formed by subjecting a surface of an oxide film with a thickness of not less than 5 nm and not more than 20 nm to a barrier type anodization.

3. The plasma processing apparatus according to claim 1 or claim 2, wherein
the constituent member (220) is an deposition-inhibitory member that prevents adhesion of products of the plasma processing.

4. The plasma processing apparatus according to claim 1, wherein
a film thickness of the aluminum sprayed film (224) is 100 µm or more.

5. The plasma processing apparatus according to claim 1, wherein
the noble metal material and the ferroelectric material are materials that constitute a memory element of a ferroelectric memory.

6. The plasma processing apparatus according to claim 1, wherein
the noble material contains at least any one of Pt (platinum), Ir (iridium), IrO₂ (iridium oxide), and SrRuO₃ (strontium ruthenium oxide).

7. The plasma processing apparatus according the claim 1, wherein
the ferroelectric material contains at least any one of PZT (Pb (Zr, Ti) O₃; lead zirconium titanate), SBT (SrBi₂Ta₂O₉; strontium bismuth tantalite), BTO (Bi₄Ti₃O₁₂; bismuth titanate), and BLT ((Bi, La)₄Ti₃O₁₂; bismuth lanthanum titanate).

8. A method of manufacturing the constituent member (220) included in the plasma processing apparatus according to one of claim 1 to claim 7, the method including:
an oxide film coating step for coating a base substance (221) made of an aluminum alloy with a barrier type anodic oxide film (223); and
a sprayed film coating step for coating the barrier type anodic oxide film (223) with an aluminum sprayed film (224) of at least 99% aluminum purity.

9. The method according to claim 8, wherein
prior to the oxide film coating step, there is further provided a step for coating the base substance (221) with an oxide film with a thickness of not less than 5 nm and not more than 20 nm,
and in the oxide film coating step, a surface of the oxide film is subjected to a barrier type anodization.

## Patentansprüche

1. Plasmaverarbeitungsvorrichtung, die ausgebildet ist, auf einem zu verarbeitenden Substrat eine Plasmaverarbeitung mit einem Edelmetallmaterial und einem ferrroelektrischen Material durchzuführen, und die einen Bestandteil (220) umfasst, der Plasma ausgesetzt ist, wobei ein Grundstoff (221) des Bestandteils (220) aus einer Aluminiumlegierung gemacht ist, **dadurch gekennzeichnet, dass**
der Bestandteil (220) angepasst ist, erhitzt zu werden, der Grundstoff (221) des Bestandteils (220) mit einem anodischen Oxidfilm (223) von einem Typ, der eine Barriere bildet, beschichtet ist, und der anodische Oxidfilm (223) von dem Typ, der eine Barriere bildet, des Weiteren mit einem aufgesprühten Aluminiumfilm (224) von zumindest 99% Aluminiumreinheit beschichtet ist.

2. Plasmaverarbeitungsvorrichtung nach Anspruch 1, wobei
der anodische Oxidfilm (223) von dem Typ, der eine Barriere bildet, dadurch geformt ist, dass eine Oberfläche eines Oxidfilms mit einer Dicke von nicht weniger als 5 nm und nicht mehr als 20 nm einer Anodisierung von einem Typ, der eine Barriere bildet, unterzogen wird.

3. Plasmaverarbeitungsvorrichtung nach Anspruch 1 oder Anspruch 2, wobei
der Bestandteil (220) ein ablagerungshemmender Teil ist, der ein Anhaften von Produkten der Plasmaverarbeitung verhindert.

4. Plasmaverarbeitungsvorrichtung nach Anspruch 1, wobei
eine Filmdicke des aufgesprühten Aluminiumfilms (224) 100 µm oder mehr beträgt.

5. Plasmaverarbeitungsvorrichtung nach Anspruch 1, wobei
das Edelmetallmaterial und das ferroelektrische Material Materialien sind, die ein Speicherelement eines ferroelektrischen Speichers bilden.

6. Plasmaverarbeitungsvorrichtung in Anspruch 1, wobei
das Edelmetallmaterial zumindest eins von Pt (Platin), Ir (Iridium), IrO₂ (Iridiumoxid), und SrRuO₃ (Strontium-Ruthenium-Oxid) beinhaltet.

7. Plasmaverarbeitungsvorrichtung nach Anspruch 1, wobei
das ferroelektrische Material zumindest eins von PZT (Pb (Zr, Ti) O₃; Blei-Zirkonat-Titanat, SBT (SrBi₂Ta₂O₉; Strontium-Bismut-Tantalit), BTO (Bi₄Ti₃O₁₂; Bismut-Titanat), und BLT ((Bi, La)₄Ti₃O₁₂; Bismut-Lanthanit-Titanat) beinhaltet.

8. Verfahren zum Herstellen des Bestandteils (220), der in der Plasmaverarbeitungsvorrichtung nach einem der Ansprüche 1 bis 7 enthalten ist, wobei das Verfahren beinhaltet:
einen Oxidfilm-Beschichtungsschritt zum Beschichten eines Grundstoffs (221), der aus einer Aluminiumlegierung gemacht ist, mit einem anodischen Oxidfilm (223) von einem Typ, der eine Barriere bildet; und
ein Aufgesprühter-Film-Beschichtungsschritt zum Beschichten des anodischen Oxidfilms (223) von dem Typ, der eine Barriere bildet, mit einem aufgesprühten Aluminiumfilm (224) von zumindest 99% Aluminiumreinheit.

9. Verfahren nach Anspruch 8, wobei
vor dem Oxidfilm-Beschichtungsschritt des Weiteren ein Schritt zum Beschichten des Grundstoffs (221) mit einem Oxidfilm mit einer Dicke von nicht weniger als 5 nm und nicht mehr als 20 nm bereitgestellt ist,
und in dem Oxidfilm-Beschichtungsschritt, eine Oberfläche des Oxidfilms einer Anodisierung von einem Typ, der eine Barriere bildet, unterzogen wird.

## Revendications

1. Dispositif de traitement par plasma, qui est configuré pour effectuer sur un substrat traité un traitement par plasma avec une matière en métal précieux et une matière ferroélectrique, et qui comprend un élément (220) constitutif qui est exposé au plasma, dans lequel une substance (221) de base de l'élément (220) constitutif est en un alliage d'aluminium, **caractérisé en ce que**
l'élément (220) constitutif est conçu pour être chauffé, la substance (221) de base de l'élément (220) constitutif est revêtue d'une pellicule (223) d'oxyde anodique de type formant barrière et la pellicule (223) d'oxyde anodique de type formant barrière est revêtue, en outre, d'une pellicule
(224) d'aluminium pulvérisée en un aluminium d'une pureté d'au moins 99 %.

2. Dispositif de traitement par plasma suivant la revendication 1, dans lequel
la pellicule (223) d'oxyde anodique de type formant barrière est formée en soumettant une surface d'une pellicule d'oxyde, d'une épaisseur qui n'est pas inférieure à 5 nm et qui n'est pas supérieure à 20 nm, à une anodisation de type barrière.

3. Dispositif de traitement par plasma suivant la revendication 1 ou 2, dans lequel
l'élément (220) constitutif est un élément d'inhibition de dépôt, qui empêche l'adhérence de produit du traitement par plasma.

4. Dispositif de traitement par plasma suivant la revendication 1, dans lequel une épaisseur de la pellicule (224) d'aluminium pulvérisée est supérieure ou égale à 100 µm.

5. Dispositif de traitement par plasma suivant la revendication 1, dans lequel
la matière de métal précieux et la matière ferroélectrique sont des matières qui constituent un élément de mémoire d'une mémoire ferroélectrique.

6. Dispositif de traitement par plasma suivant la revendication 1, dans lequel
la matière précieuse contient au moins l'un quelconque du Pt (platine), Ir (iridium), IrO₂ (oxyde d'iridium) et SrRuO₃ (oxyde de strontium et de ruthénium).

7. Dispositif de traitement par plasma suivant la revendication 1, dans lequel
la matière ferroélectrique contient au moins l'une quelconque de PZT (Pb (Zr, Ti) O₃ titanate de plomb et de zirconium), SBT (SrBi₂Ta₂O₉ tantalite de strontium et de bismuth), BTO (Bi₄Ti₃O₁₂ titanate de bismuth), et BLT ((Bi, La)₄Ti₃O₁₂ : titanate de bismuth et de lanthane).

8. Procédé de fabrication de l'élément (220) constitutif inclus dans le dispositif de traitement par plasma suivant l'une des revendications 1 à 7, le procédé comprenant :
un stade de dépôt d'une pellicule d'oxyde pour revêtir une substance (221) de base en un alliage d'aluminium et d'une pellicule (223) d'oxyde anodique de type formant barrière, et
un stade de dépôt d'une pellicule pulvérisée pour revêtir la pellicule (223) d'oxyde anodique de type formant barrière d'une pellicule (224) d'aluminium pulvérisée en un aluminium d'une pureté d'au moins 99 %.

9. Procédé suivant la revendication 8, dans lequel
avant le stade de dépôt de la pellicule d'oxyde, il est prévu en outre un stade de revêtement de la substance (221) de base par une pellicule d'oxyde d'une épaisseur qui n'est pas plus petite que 5 nm et qui n'est pas plus grande que 20 nm,
et dans le stade de dépôt d'une pellicule d'oxyde, on soumet une surface de la pellicule d'oxyde à une anodisation du type barrière.
